(19) Europäisches Patentamt
European Patent Office
Office européen des brevets

(11) **EP 4 726 958 A1**

(12) **EUROPEAN PATENT APPLICATION**
published in accordance with Art. 153(4) EPC

(43) Date of publication:
**15.04.2026 Bulletin 2026/16**

(21) Application number: **25783115.6**

(22) Date of filing: **07.03.2025**

(51) International Patent Classification (IPC):
**H02J 7/00** (2026.01)     **G01R 31/3842** (2019.01)

(52) Cooperative Patent Classification (CPC):
**G01R 31/3842; H02J 7/00**

(86) International application number:
**PCT/KR2025/099630**

(87) International publication number:
**WO 2025/211939 (09.10.2025 Gazette 2025/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.04.2024 KR 20240045427**

(71) Applicant: **LG Energy Solution, Ltd.
Seoul 07335 (KR)**

(72) Inventors:
• **KIM, Seung-Choo
Daejeon 34122 (KR)**
• **KIM, Myung-Hwan
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **SYSTEM CONTROL APPARATUS AND SYSTEM CONTROL METHOD FOR BATTERY CHARGING-DISCHARGING SYSTEM**

(57)     There are provided a system control apparatus and a system control method for a battery charging/discharging system. The system control apparatus is used for the battery charging/discharging system including first to m-th converters and first to m-th charging/discharging facilities respectively connected through first to m-th nodes on a shared power line. The system control apparatus includes first to m-th controllers to acquire first to m-th facility operation information including a measured voltage value and a measured current value respectively indicating a voltage and a current of a direct current (DC) power port of each of the first to m-th converters. An i-th controller is configured to determine an i-th target voltage value corresponding to an i-th converter based on i-th facility operation information, and transmit an i-th control command indicating the i-th target voltage value to the i-th converter.

FIG. 1

Battery charging/discharging system — 10
Power conversion system — 100
System control apparatus — 200

EP 4 726 958 A1

**Description**

TECHNICAL FIELD

The present disclosure relates to a control technology for improving the efficiency of a charging/discharging process performed by a battery charging/discharging system.

This application is based on and claims priority to Korean Patent Application No. 10-2024-0045427 filed on April 3, 2024 in the Republic of Korea, the disclosure of which is incorporated herein by reference.

BACKGROUND

Recently, there has been a rapid increase in the demand for portable electronic products such as laptop computers, video cameras and mobile phones, and with the extensive development of electric vehicles, accumulators for energy storage, robots and satellites, many studies are being made on high performance batteries that can be repeatedly charged and discharged.

Batteries on the market now include nickel-cadmium batteries, nickel-hydrogen batteries, nickel-zinc batteries, lithium batteries and the like, and among them, lithium batteries have little or no memory effect, and thus they are gaining more attention than nickel-based batteries for their advantages that recharging can be done whenever it is convenient, the self-discharge rate is very low and the energy density is high.

Batteries are manufactured as finished products by performing an assembly process and a charging/discharging process in a sequential order. In the assembly process, a stack of a positive electrode, a negative electrode and a separator is housed in an outer packaging together with an electrolyte, followed by sealing. In the charging/discharging process, a predetermined charging/discharging procedure is performed on the batteries having undergone the assembly process. When the charging/discharging process is performed, solid electrolyte interphase (SEI) is formed on the negative electrode surface of the batteries, establishing the intended electrical properties.

The batteries having undergone the assembly process are sequentially transported on a battery tray to a battery charging/discharging system, and the battery charging/discharging system sequentially performs the charging/discharging process on the batteries in a first-in, first-out manner.

The battery charging/discharging system includes a plurality of power facility sets provided to take responsibility for the charging/discharging process for each battery tray. Because a large amount of power is required for the operation of the battery charging/discharging system, there is a risk of overloading on a specific power facility set. This risk may be mitigated to some extent by connecting the plurality of power facility sets in parallel to share the load.

However, during load sharing operation, the plurality of power facility sets cannot supply or regenerate equal power, and due to this limitation, larger or smaller power than power required for the specific power facility set is supplied.

In addition, the components (i.e., a converter and a charging/discharging facility) of each power facility set are directly or indirectly connected to each other via a wired communication network. This structure has an advantage of operating the components according to the condition of each component. For example, a signal notifying the start of a charging operation by the charging/discharging facility of the specific power facility set may be transmitted to the converter included in the same power facility set via the wired communication network, and accordingly, the converter may quickly supply the optimal charge power required for the charging/discharging facility. However, when all the converters and the charging/discharging facilities of the battery charging/discharging system are connected via the wired communication network, circuit wiring is complex and it requires a lot of time and financial resources to maintain and repair.

DISCLOSURE

Technical Problem

The present disclosure is designed to solve the above-described problems, and therefore the present disclosure is directed to providing an apparatus and method for controlling each converter to allow a converter and a charging/discharging facility of each of a plurality of power facility sets to operate using power exchanged between them.

In addition, the present disclosure is directed to providing an apparatus and method without a wired communication network for the components (i.e., the converter and the charging/discharging facility) of each power facility set.

These and other objectives and advantages of the present disclosure may be understood from the following description and will become apparent from the embodiments of the present disclosure. Also, it will be easily understood that the objectives and advantages of the present disclosure may be realized by the means set forth in the appended claims and a combination thereof.

Technical Solution

A system control apparatus according to an aspect of the present disclosure is used for a battery charging/discharging system including first to m-th converters and first to m-th charging/discharging facilities respectively connected through first to m-th nodes on a shared power line. The system control apparatus includes first to m-th controllers to acquire first to m-th facility operation information including a measured voltage value and a measured current value respectively indicating a voltage and a current of a direct current (DC) power port of each of the first to m-th converters. An i-th controller of the first to m-th controllers may be configured to determine an i-th target voltage value corresponding to an i-th converter of the first to m-th converters based on i-th facility operation information of the first to m-th facility operation information, and transmit an i-th control command indicating the i-th target voltage value to the i-th converter. m is a natural number of 2 or greater and i is a natural number equal to or smaller than m.

The i-th controller may be configured to perform the following operations for increasing a connection strength between an i-th charging/discharging facility of the first to m-th charging/discharging facilities and the i-th converter when a first control mode is set for the i-th converter, the operations including: an operation of determining an i-th node voltage value indicating a voltage of an i-th node of the first to m-th nodes based on the i-th facility operation information; and an operation of determining the i-th target voltage value based on a voltage difference between a predetermined first reference voltage value and the i-th node voltage value.

The i-th controller may be configured to determine the i-th node voltage value by subtracting an i-th voltage drop value corresponding to the i-th measured current value from the i-th measured voltage value.

The i-th controller may be configured to determine the i-th target voltage value by applying a predetermined positive correspondence relationship to the voltage difference to reduce the voltage difference.

The i-th controller may be configured to switch a control mode for the i-th converter from the first control mode to a second control mode for reducing the connection strength between the i-th charging/discharging facility and the i-th converter when a duration of a flow of current from the i-th node to the i-th converter reaches a first reference time while the first control mode is set for the i-th converter.

The i-th controller may be configured to determine the i-th target voltage value to be equal to a second reference voltage value when the second control mode is set for the i-th converter.

The second reference voltage value may be equal to or larger than the first reference voltage value.

The i-th controller may be configured to disable the second control mode and enter the first control mode when the flow of current from the i-th converter to the i-th node lasts for a second reference time or longer while the second control mode is set for the i-th converter.

An i-th shortest path resistance value may be smallest among first to m-th shortest path resistance values of the i-th converter. The first to m-th shortest path resistance values of the i-th converter may correspond to shortest paths from the DC power port of the i-th converter to the DC power ports of the first to m-th charging/discharging facilities, respectively.

A battery charging/discharging system according to another aspect of the present disclosure includes the system control apparatus.

A system control method according to still another aspect of the present disclosure is performed by a system control apparatus for a battery charging/discharging system including first to m-th converters respectively connected to first to m-th nodes on a shared power line, and first to m-th charging/discharging facilities respectively connected to the first to m-th nodes, through first to m-th main lines. The system control method includes acquiring, by first to m-th controllers included in the system control apparatus, first to m-th facility operation information including a measured voltage value and a measured current value respectively indicating a voltage and a current of a DC power port of each of the first to m-th converters, determining, by an i-th controller of the first to m-th controllers, an i-th target voltage value corresponding to an i-th converter of the first to m-th converters based on i-th facility operation information of the first to m-th facility operation information, and transmitting, by the i-th controller, an i-th control command indicating the i-th target voltage value to the i-th converter. m is a natural number of 2 or greater, and i is a natural number equal to or smaller than m.

The determining of the i-th target voltage value may include performing the following steps for increasing a connection strength between an i-th charging/discharging facility of the first to m-th charging/discharging facilities and the i-th converter when a first control mode is set for the i-th converter, the steps including determining an i-th node voltage value indicating a voltage of an i-th node of the first to m-th nodes based on the i-th facility operation information, and determining the i-th target voltage value based on a voltage difference between a predetermined first reference voltage value and the i-th node voltage value.

The determining of the i-th target voltage value may include determining the i-th target voltage value by applying a predetermined positive correspondence relationship to the voltage difference to reduce the voltage difference.

The determining of the i-th target voltage value may further include switching a control mode for the i-th converter from the first control mode to a second control mode for reducing the connection strength between the i-th charging/discharging facility and the i-th converter when a duration of a flow of current from the i-th node to the i-th converter reaches a first reference time.

The determining of the i-th target voltage value may further include determining the i-th target voltage value to be equal to a second reference voltage value when the second control mode is set for the i-th converter.

Advantageous Effects

According to at least one of the embodiments of the present disclosure, it may be possible to provide the apparatus and method for controlling each converter to allow the converter and the charging/discharging facility of each of the plurality of power facility sets included in the battery charging/discharging system to operate using power exchanged between them.

In addition, according to at least one of the embodiments of the present disclosure, it may be possible to eliminate a wired communication network for the components of each power facility set, thereby simplifying circuit wiring and saving time and financial resources required for maintenance and repair.

In addition, according to at least one of the embodiments of the present disclosure, when some of the plurality of converters are in power supply operation and the remaining converters are in power regeneration operation, regenerative power of each converter in power regeneration operation may be supplied to at least one converter in power supply operation, thereby reducing unnecessary line loss (for example, electrical energy lost by heat generated in the wire), regeneration loss (for example, electrical energy converted to alternating current (AC) power and escaping to the outside) and conversion loss (for example, electrical energy lost by heat generated during direct current (DC)-AC conversion operation of the converter).

The effects of the present disclosure are not limited to the aforementioned effects, and these and other effects will be clearly understood by those skilled in the art from the appended claims.

BRIEF DESCRIPTION OF THE DRAWINGS

The accompanying drawings illustrate exemplary embodiments of the present disclosure and together with the following detailed description, serve to provide a better understanding of the technical aspects of the present disclosure, and thus the present disclosure should not be construed as being limited to the drawings.

FIGS. 1 to 3 are diagrams referenced in describing the overall architecture of a battery charging/discharging system 10 according to an embodiment of the present disclosure.
FIG. 4 is a diagram referenced in describing a connection relationship of power facility sets.
FIG. 5 is a diagram referenced in describing a first control mode for a converter in each power facility set.
FIG. 6 is a diagram referenced in describing a second control mode for a converter in each power facility set.
FIG. 7 is a diagram referenced in describing an example of voltage relationship of a converter, a node and a charger/discharger associated with a first control mode of a power facility set.
FIG. 8 is a diagram referenced in describing another example of voltage relationship of a converter, a node and a charging/discharging facility associated with a first control mode of a power facility set.

FIG. 9 is a diagram referenced in describing another example of voltage relationship of a converter, a node and a charger/discharger associated with a first control mode of a power facility set.
FIG. 10 is a diagram referenced in describing an example of voltage relationship of a converter, a node and a charging/discharging facility associated with a second control mode of a power facility set.
FIG. 11 is a diagram referenced in describing a disadvantage of maintaining a control mode for a converter in a power regeneration operation at a first control mode.
FIG. 12 is a diagram referenced in describing an advantage of switching a control mode for a converter in a power regeneration operation from a first control mode to a second control mode.
FIG. 13 is a flowchart schematically illustrating a system control method according to another embodiment of the present disclosure.
FIG. 14 is a flowchart schematically illustrating an example of subroutines that may be included in step S1320 of FIG. 13.
FIG. 15 is a flowchart schematically illustrating another example of subroutines that may be included in step S1320 of FIG. 13.

BEST MODE

Hereinafter, exemplary embodiments of the present disclosure will be described in detail with reference to the accompanying drawings. Prior to the description, it should be understood that the terms or words used in the specification and the appended claims should not be construed as being limited to general and dictionary meanings, and rather, should be interpreted based on the meanings and concepts corresponding to the technical aspects of the present disclosure on the basis of the principle that the inventor is allowed to define the terms appropriately for the best explanation.

Therefore, the embodiments described herein and the illustrations shown in the drawings are exemplary embodiments of the present disclosure to describe the technical aspects of the present disclosure and not intended to be limiting, so it should be understood that a variety of other equivalents and modifications could be made thereto at the time the application was filed.

The terms including the ordinal numbers such as "first", "second" and the like, are used to distinguish one element from another among various elements, and not intended to limit the elements by the terms.

Unless the context clearly indicates otherwise, the terms "comprise" and "include" when used in this specification, specify the presence of the stated elements, but do not preclude the presence or addition of one or more other elements. Additionally, the term "unit" as used herein refers to a processing unit of at least one function or operation, and may be implemented by hardware and software either alone or in combination.

In addition, throughout this specification, it will be further understood that when an element is referred to as being "connected to" another element, it may be directly connected to the other element or intervening elements may be present.

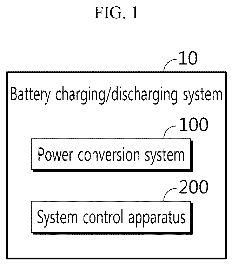

FIGS. 1 to 3 are diagrams referenced in describing the overall architecture of a battery charging/discharging system according to an embodiment of the present disclosure.

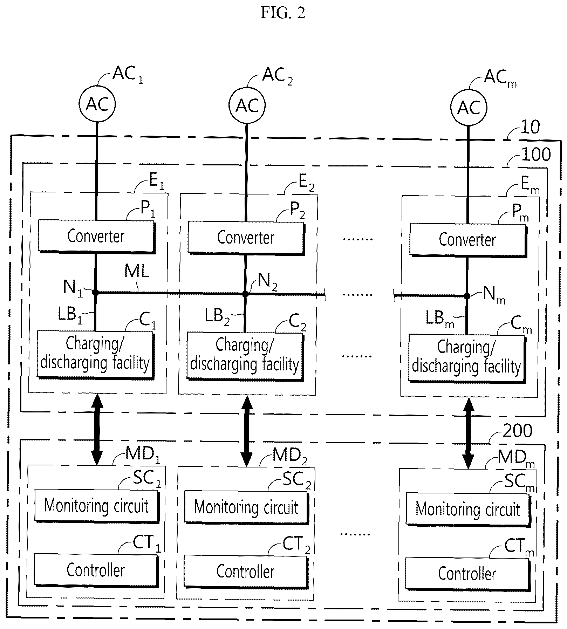

Referring to FIGS. 1 and 2, the battery charging/discharging system 10 includes a power conversion system 100 and a system control apparatus 200.

The power conversion system 100 includes power facility sets $E_1 \sim E_m$. m is a natural number of 2 or greater. The power facility sets $E_1 \sim E_m$ may be electrically coupled through a shared power line ML to enable bidirectional power supply. The term 'line' as used herein may include either a busbar or an electric cable, or a combination thereof.

When i is a natural number that is equal to or smaller than m, the power facility set $E_i$ of the power conversion system 100 includes a converter $P_i$ and a charging/discharging facility $C_i$. Accordingly, the power conversion system 100 includes converters $P_1 \sim P_m$ and charging/discharging facilities $C_1 \sim C_m$.

The converter $P_i$ may have an alternating current (AC) input/output port for coupling with an AC power network $AC_i$. The converter $P_i$ may have a direct current (DC) power port $TP_i$ for coupling with the shared power line ML. The converter $P_i$ includes an AC-DC converter. The system control apparatus 200 may perform ON/OFF control for the AC-DC converter or adjust the magnitude of DC power supplied from the converter $P_i$ to the shared power line ML according to the condition of the AC power network $AC_i$.

The operation mode may include a power supply mode, a power regeneration mode and a rest mode. During operation in the power supply mode, the converter $P_i$ converts AC power supplied from the AC power network $AC_i$ to DC power and supplies it to the shared power line ML. The voltage of DC power supplied from the converter $P_i$ to the shared power line ML may be maintained at a reference voltage (preset to, for example, 370 V) by feedback control. During operation in the power regeneration mode, the converter $P_i$ converts DC power supplied through the shared power line ML to AC power and supplies it to the AC power network $AC_i$. For reference, the converter may be referred to as a power conversion facility.

The charging/discharging facility $C_i$ may have a DC power port $TC_i$ for coupling with the shared power line ML. The charging/discharging facility $C_i$ may have a charging/discharging port for coupling with a charging/discharging port of a battery tray. The charging/discharging facility $C_i$ may include at least one bidirectional DC-DC converter. The charging/discharging facility $C_i$ may relay bidirectional power transfer between the battery tray transported to the charging/discharging facility $C_i$ and the shared power line ML.

The DC power port $TP_i$ of the converter $P_i$ and the DC power port $TC_i$ of the charging/discharging facility $C_i$ may be electrically connected through a line $LB_i$. The line $LB_i$ may be referred to as an 'i-th main line'. The nodes $N_1 \sim N_m$ shown in FIG. 2 indicate points of connection of the shared power line ML to lines $LB_1 \sim LB_m$. That is, the line $LB_i$ is connected to the shared power line ML at the node $N_i$.

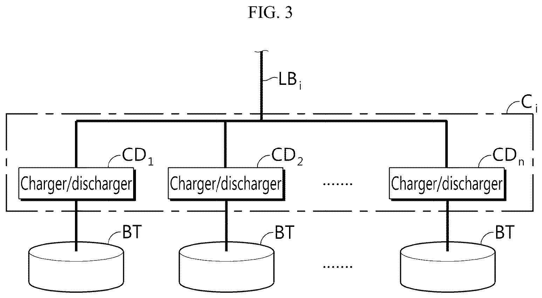

The charging/discharging facility $C_i$ may include at least one charger/discharger CD. FIG. 3 shows the charging/discharging facility $C_i$ including first to n-th chargers/dischargers $CD_1 \sim CD_n$ (n is a natural number of 2 or greater). The first to n-th chargers/dischargers $CD_1 \sim CD_n$ of the charging/discharging facility $C_i$ may independently or dependently operate in a battery charge mode, a battery discharge mode or a rest mode.

Each battery tray BT transported to the battery charging/discharging system 10 in a sequential order after the assembly process undergoes a charging/-discharging process by any one charging/discharging facility of the battery charging/discharging system 10 in a first-in, first-out manner.

The charging/discharging process that the charging/discharging facility $C_i$ performs on the battery tray BT includes at least one charging stage and at least one discharging stage performed in an alternating manner. When the charging/discharging process starts, the charging stage is performed first, and then the discharging stage is performed. Each charging stage may include at least one of a constant current charging procedure, a constant power charging procedure or a constant voltage charging procedure. Each discharging stage may include at least one of a constant current discharging procedure, a constant power discharging procedure or a constant voltage discharging procedure.

Additionally, the charging/discharging facility included in a certain power facility set may operate in the battery charge mode, the battery discharge mode and the rest mode, independently of the charging/discharging facility included in another facility set.

Referring to FIGS. 2 and 3, during operation in the battery charge mode, the charging/discharging facility $C_i$ may convert DC power supplied through the DC power port $TC_i$ connected to the converter $P_i$ side to charge power having a predetermined voltage level, and output it to the DC power port $TT_i$ connected to the battery tray BT side. During operation in the battery discharge mode, the charging/discharging facility $C_i$ may convert discharge power of the battery tray BT supplied through the DC power port $TT_i$ to DC power having a predetermined voltage level, and output it to the DC power port $TC_i$.

When the charging/discharging facility $C_i$ includes the first to n-th chargers/dischargers $CD_1 \sim CD_n$, the operation of the charging/discharging facility $C_i$ in the battery charge mode may represent the charging/-discharging facility $C_i$ in a charge dominant state. The charge dominant state may refer to a state in which the total charge power of the charging/discharging facility $C_i$ is larger than the total discharge power. In addition, the operation of the charging/discharging facility $C_i$ in the battery discharge mode may represent the charging/discharging facility $C_i$ in a discharge dominant state. The discharge dominant state may refer to a state in which the total charge power of the charging/discharging facility $C_i$ is smaller than the total discharge power.

The total charge power of the charging/discharging facility $C_i$ may indicate power supplied to the charger/discharger(s) in the battery charge mode among the first to n-th chargers/dischargers $CD_1 \sim CD_n$. The total discharge power of the charging/discharging facility $C_i$ may refer to power regenerated from the charger/discharger(s) in the battery discharge mode among the first to n-th chargers/dischargers $CD_1 \sim CD_n$.

The system control apparatus 200 includes first to m-th facility management units $MD_1 \sim MD_m$. The first to m-th facility management units $MD_1 \sim MD_m$ may independently perform monitoring and control operations for each of the first to m-th converters $P_1 \sim P_m$ without communication with one another.

An i-th facility management unit $MD_i$ includes an i-th monitoring circuit $SC_i$ and an i-th controller $CT_i$. Accordingly, the system control apparatus 200 includes first to m-th monitoring circuits $SC_1 \sim SC_m$ and first to m-th controllers $CT_1 \sim CT_m$.

Hereinafter, for convenience of description, in the description that is shared between the first to m-th monitoring circuits $SC_1 \sim SC_m$, the symbol SC or $SC_i$ may be affixed, and in the description that is shared between the first to m-th controllers $CT_1 \sim CT_m$, the symbol CT or $CT_i$ may be affixed.

The first to m-th monitoring circuits $SC_i \sim SC_m$ may monitor the condition of the first to m-th converters $P_1 \sim P_m$, respectively. Additionally, the first to m-th monitoring circuits $SC_i \sim SC_m$ may monitor the condition of the first to m-th charging/discharging facilities $C_1 \sim C_m$, respectively.

Although FIG. 2 shows the i-th facility management unit $MD_i$ physically independent from the i-th converter $P_i$, the i-th facility management unit $MD_i$ may be included in the i-th converter $P_i$. In this case, the i-th facility management unit $MD_i$ may be configured to monitor and control the power conversion circuit (for example, the AC-DC converter) of the i-th converter $P_i$.

Although FIG. 2 shows the i-th monitoring circuit $SC_i$ and the i-th controller $CT_i$ physically independent of each other, this is provided by way of illustration, and the i-th monitoring circuit $SC_i$ may be included in the i-th controller $CT_i$.

The monitoring circuit $SC_i$ may measure the voltage and current of the DC power input and output to the converter $P_i$. The monitoring circuit $SC_i$ may measure the voltage and current of the DC power input and output to the charging/discharging facility $C_i$.

The controller $CT_i$ may include, in hardware, at least one of application specific integrated circuits (ASICs), digital signal processors (DSPs), digital signal processing devices (DSPDs), programmable logic devices (PLDs), field programmable gate arrays (FPGAs), microprocessors, or electrical units for performing other functions.

The controller $CT_i$ may have a built-in memory. The memory may include at least one type of storage medium of flash memory type, hard disk type, Solid State Disk (SSD) type, Silicon Disk Drive (SDD) type, multimedia card micro type, random access memory (RAM), static random access memory (SRAM), read-only memory (ROM), electrically erasable programmable read-only memory (EEPROM) or programmable read-only memory (PROM). The memory may store data and programs required for the operation by the controller $CT_i$. The memory may store data indicating the result of the operation by the controller $CT_i$.

The memory may pre-store a shortest path resistance value of each converter with respect to each charging/discharging facility of the power conversion system 100. In this specification, the shortest path resistance value from a certain converter to a certain charging/discharging facility may indicate the total resistance value of the shortest path connecting the DC power port of the converter to the DC power port of the charging/discharging facility.

When x and y are different natural numbers equal to or smaller than m, both the shortest path resistance value of the converter $P_y$ with respect to the charging/discharging facility $C_x$ and the shortest path resistance value of the converter $P_x$ with respect to the charging/discharging facility $C_y$ may be smaller than the shortest path resistance value of the converter $P_x$ with respect to the charging/discharging facility $C_x$. In addition, both the shortest path resistance value of the converter $P_y$ with respect to the charging/discharging facility $C_x$ and the shortest path resistance value of the converter $P_x$ with respect to the charging/discharging facility $C_y$ may be smaller than the shortest path resistance value of the converter $P_y$ with respect to the charging/discharging facility $C_y$. That is, the i-th shortest path resistance value is the smallest one of first to m-th shortest path resistance values of the i-th converter $P_i$.

The controller $CT_1 \sim CT_m$ may collect measurement data from the monitoring circuits $SC_1 \sim SC_m$ and monitor first to m-th facility operation information corresponding respectively to the first to m-th power facility sets $E_1 \sim E_m$.

The first to m-th controllers $CT_1 \sim CT_m$ may determine a target voltage value of the first to m-th converters $P_1 \sim P_m$ based on the first to m-th facility operation information, respectively. The method for determining the target voltage value of the i-th converter $P_i$ may rely on the operation mode individually set for the i-th converter $P_i$.

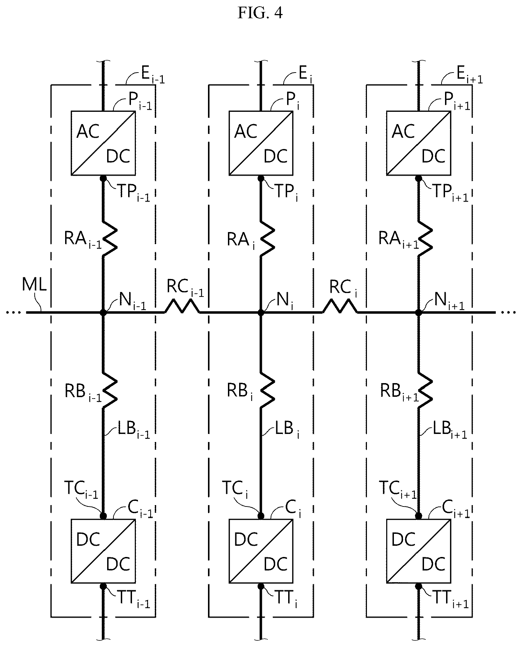

FIG. 4 is a diagram referenced in describing the connection relationship of the power facility sets. For convenience of description, FIG. 4 shows only three adjacent power facility sets $E_{i-1}$, $E_i$, $E_{i+1}$ of the power facility sets $E_1 \sim E_m$.

The memory may record line resistance values $RA_1 \sim RA_m$ preset for the converters $P_1 \sim P_m$, respectively.

Referring to FIG. 4, $RA_i$ indicates the line resistance value of a line section (a portion of $LB_i$) from the DC power port $TP_i$ of the converter $P_i$ to the node $N_i$. $RA_{i-1}$ indicates the line resistance value of a line section (a portion of $LB_{i-1}$) from the DC power port $TP_{i-1}$ of the converter $P_{i-1}$ to the node $N_{i-1}$. $RA_{i+1}$ indicates the line resistance value of a line section (a portion of $LB_{i+1}$) from the DC power port $TP_{i+1}$ of the converter $P_{i+1}$ to the node $N_{i+1}$.

In addition, the memory may record line resistance values $RB_1 \sim RB_m$. In the line resistance values $RB_1 \sim RB_m$, $RB_i$ may indicate a preset resistance value of a line section (a portion of $LB_i$) connecting the node $N_i$ to the DC power port $TC_i$ of the charging/discharging facility $C_i$. Furthermore, the memory may record line resistance values $RC_1 \sim RC_{m-1}$. In the line resistance values $RC_1 \sim RC_{m-1}$, $RC_i$ may indicate a preset resistance value of a line section (a portion of ML) connecting two adjacent nodes $N_i$, $N_{i+1}$ of the nodes $N_1 \sim N_m$.

The first control mode for the converter $P_i$ of the power facility set $E_i$ may be a control mode for increasing the connection strength between the converter $P_i$ and the charging/discharging facility $C_i$. The first control mode may be referred to as a 'droop operation mode'.

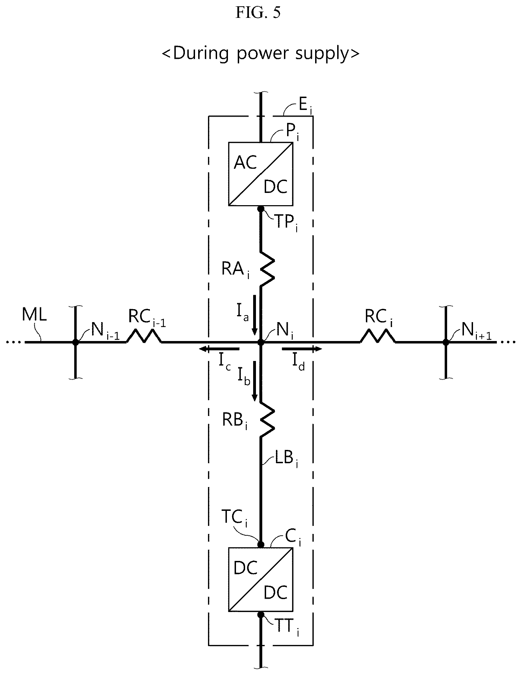

FIG. 5 is a diagram referenced in describing the first control mode for the converter in each power facility set. To help understanding, the description will be made based on a situation where the converter $P_i$ of the power facility set $E_i$ of the power facility sets $E_1 \sim E_m$ is in the power supply operation. The following description of the power facility set $E_i$ may be shared between each of the power facility sets $E_1 \sim E_m$.

Referring to FIG. 5, the first to m-th controllers CT may set the control mode for the converter $C_i$ to the first control mode when the operation information of the converter $C_i$ meets a predetermined first mode setting condition.

The first to m-th controllers CT may determine an i-th node voltage value indicating the voltage of the i-th node $N_i$ based on the i-th facility operation information while the first control mode is set for the converter $C_i$. For reference, the first to m-th monitoring circuits SC may measure the voltage and current of the DC power port $TP_i$ and generate i-th measurement data indicating an i-th measured voltage value and an i-th measured current value. The first to m-th controllers CT may determine the i-th node voltage value based on the i-th measurement data. Accordingly, it may be possible to eliminate a sensing circuit for measuring the voltage of the i-th node $N_i$, thereby providing advantages of simplifying the circuit wiring and easing the maintenance and repair.

The first to m-th controllers CT determine the i-th node voltage value by subtracting an i-th voltage drop value corresponding to the i-th measured current value from the i-th measured voltage value. The relationship of the i-th measured voltage value, the i-th measured current value, the i-th voltage drop value and the i-th node voltage value may be represented by Equations 1-1 and 1-2 below.

<Equation 1-1>

$$V_{node}[i] = V_{P\_t}[i] - V_{P\_drop}[i]$$

<Equation 1-2>

$$V_{P\_drop}[i] = I_{P\_t}[i] \times RA_i$$

In Equations 1-1 and 1-2, $V_{node}[i]$ denotes the i-th node voltage value, $V_{P\_drop}[i]$ denotes the i-th voltage drop value, and $I_{P\_t}[i]$ denotes the i-th measured current value. $V_{P\_drop}[i]$ may be the result of applying the Ohm's law to $I_{P\_t}[i]$ and $RA_i$. Here, $I_{P\_t}[i]$ having a positive value represents the flow of current from the DC power port $TP_i$ to the node $N_i$, and $I_{P\_t}[i]$ having a negative value represents the flow of current from the node $N_i$ to the DC power port $TP_i$.

The first control mode for the converter $C_i$ may be a control mode for matching the i-th node voltage value with a first reference voltage value. Accordingly, the first to m-th controllers CT determine the target voltage value of the converter $C_i$ based on a voltage difference between the first reference voltage value and the i-th node voltage value.

Ideally, the target voltage value for the converter $C_i$ and the measured voltage value of the DC power port $TP_i$ are equal. However, due to signal delay or noise, a difference may exist between the target voltage value for the converter $C_i$ and the measured voltage value of the DC power port $TP_i$ to a certain degree. In addition, the voltage of the i-th node $N_i$ may change under the influence of the operational state of the charging/discharging facility $C_i$ and the voltage of the adjacent nodes $N_{i-1}$, $N_{i+1}$. Accordingly, the controller $CT_i$ may repeat the operation of determining (updating) the target voltage value of the converter $C_i$ periodically or aperiodically while the first control mode is set for the converter $C_i$.

For example, in FIG. 5, assume that both the voltage value of the node $N_{i-1}$ and the voltage value of the node $N_{i+1}$ are kept equal to the first reference voltage value. According to the Kirchhoff's current law, the current ($I_a = I_{P\_t}[i]$) is equal to the sum of current $I_b$, current $I_c$ and current $I_d$. In this instance, when the i-th node voltage value is also equal to the first reference voltage value, both a voltage difference between the node $N_i$ and the node $N_{i-1}$ and a voltage difference between the node $N_i$ and the node $N_{i+1}$ will be 0 [V]. Thus, the flow of current between the node $N_i$ and the node $N_{i-1}$ and the flow of current between the node $N_i$ and the node $N_{i+1}$ disappear (i.e., $I_c = I_d = 0[A]$), thereby allowing the flow of current from any one of the converter $P_i$ and the charging-/discharging facility $C_i$ to the other (i.e., $I_a = I_b$). Accordingly, the converter $P_i$ is controlled by the controller $CT_i$ according to the first control mode, resulting in stronger connection strength between the converter $P_i$ and the charging/discharging facility $C_i$.

As opposed to the above-described example, assume that both the voltage value of the node $N_{i-1}$ and the voltage value of the node $N_{i+1}$ are larger than the first reference voltage value. In this case, $I_c$ and $I_d$ are smaller than 0[A], and this represents the flow of current from the node $N_{i-1}$ to the node $N_i$ and the flow of current from the node $N_{i+1}$ to the node $N_i$. Accordingly, $I_a = I_{P\_t}[i] < I_d$, and the connection strength between the converter $P_i$ and the charging/discharging facility $C_i$ may not be weak.

While the converter $P_i$ and the charging-/discharging facility $C_i$ are strongly connected to each other, the flow of current from the node $N_i$ to the node $N_{i-1}$ or the node $N_{i+1}$ may be suppressed, thereby allowing the power supply from any one of the converter $P_i$ and the charging/discharging facility $C_i$ to the other.

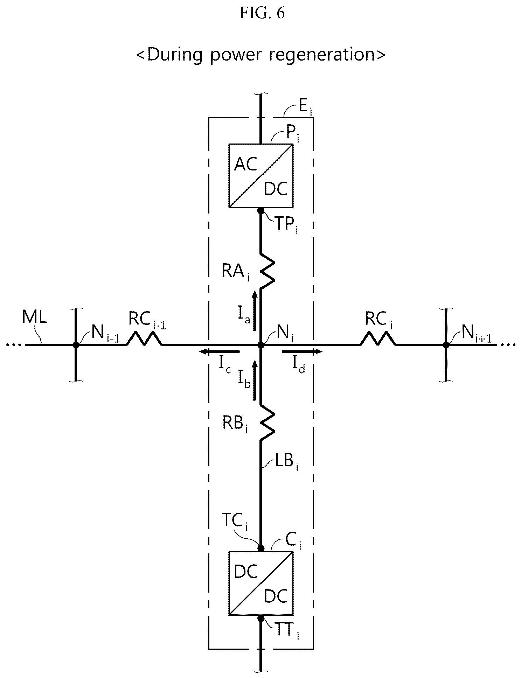

FIG. 6 is a diagram referenced in describing the second control mode for the converter in each power facility set. To help understanding, the description will be made based on a situation where the converter $P_i$ of the power facility set $E_i$ of the power facility sets $E_1 \sim E_m$ is in power regeneration operation. The second control mode for the converter $P_i$ of the power facility set $E_i$ may be a control mode for reducing the connection strength between the converter $P_i$ and the charging/discharging facility $C_i$. The following description of the power facility set $E_i$ may be shared between each of the power facility sets $E_1 \sim E_m$.

Referring to FIG. 6, the controller $CT_i$ may set the control mode for the converter $C_i$ to the second control mode when the operation information of the converter $C_i$ meets a predetermined second mode setting condition.

The controller $CT_i$ may keep the target voltage value of the converter $C_i$ equal to a second reference voltage value while the second control mode is set for the converter $C_i$. The second reference voltage value may be equal to or larger than the first reference voltage value.

The second control mode for the converter $C_i$ may be a control mode for making the i-th node voltage value larger than the first reference voltage value.

For example, in FIG. 6, assume that both the voltage value of the node $N_{i-1}$ and the voltage value of the node $N_{i+1}$ are kept equal to the first reference voltage value. As opposed to FIG. 5, in FIG. 6, the sum of current ($I_a = I_{P\_t}[i]$), current $I_b$ and current $I_c$ is equal to the current $I_d$. In this instance, because the i-th node voltage value is larger than the second reference voltage value, both the voltage difference between the node $N_i$ and the node $N_{i-1}$ and the voltage difference between the node $N_i$ and the node $N_{i+1}$ are larger than 0 [V]. Thus, the flow of current $I_c$ from the node $N_i$ to the node $N_{i-1}$ and the flow of current $I_d$ from the node $N_i$ to the node $N_{i+1}$ are generated, and as a result, the current ($I_a = I_{P\_t}[i]$ flowing from the node $N_i$ to

the converter $P_i$ is smaller than the current $I_b$ flowing from the charging/discharging facility $C_i$ to the node $N_i$. Accordingly, as the converter $P_i$ is controlled by the controller $CT_i$ according to the second control mode, the connection strength between the converter $P_i$ and the charging/discharging facility $C_i$ is reduced.

When the second control mode is set for the converter $P_i$ during the power regeneration operation of the converter $P_i$, the flow of current from the node $N_i$ to the node $N_{i-1}$ or the node $N_{i+1}$ is not suppressed due to the low connection strength between the converter $P_i$ and the charging/discharging facility $C_i$. Accordingly, some of the power supplied from the charging/discharging facility $C_i$ to the node $N_i$ is provided as the charge power required for the other charging/discharging facilities $C_{i-1}$, $C_{i+1}$. As a result, there are advantages of reducing the amount of regenerative power flowing back to the AC power network $AC_i$, and reducing the conversion loss inevitably accompanied by the power regeneration operation of the converter $P_i$.

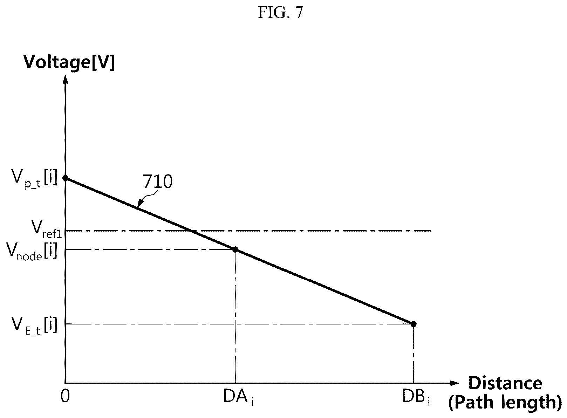

FIG. 7 is a diagram referenced in describing an example of voltage relationship of the converter, the node and the charging/discharging facility associated with the first control mode of the power facility set. To help understanding, the description will be made based on a situation where the converter $P_i$ set to the first control mode is in power supply operation.

Referring to FIG. 7, $V_{P\_t}[i]$ indicates the i-th measured voltage value, $V_{node}[i]$ indicates the i-th node voltage value, $V_{ref1}$ indicates the first reference voltage value, and $V_{E\_t}[i]$ indicates the voltage value of the DC power port $TC_i$ of the charger/discharger $C_i$. For reference, $V_{E\_t}[i]$ is not measured or estimated by the system control apparatus 200, and is for the purpose of convenience of description of the relationship between $V_{P\_t}[i]$ and $V_{node}[i]$.

$DA_i$ indicates the length from the DC power port $TP_i$ to the node $N_i$ (corresponding to the line resistance value $RA_i$). $DB_i$ indicates the length from the DC power port $TP_i$ to the DC power port $TC_i$ of the charger/discharger $C_i$ (corresponding to the total resistance value of the line $LB_i = RA_i + RB_i$). Because the converter $P_i$ is in power supply operation (for example, in FIG. 5, $I_a > 0$ [A]), $V_{P\_t}[i]$ is the largest and $V_{E\_t}[i]$ is the smallest. Accordingly, the slope of a voltage curve 710 passing through $V_{P\_t}[i]$, $V_{node}[i]$ and $V_{E\_t}[i]$ is a negative value.

In FIG. 7, $V_{ref1} > V_{node}[i]$, and it is necessary to increase $V_{node}[i]$. To increase $V_{node}[i]$, it is necessary to increase $V_{P\_t}[i]$. Accordingly, the controller $CT_i$ may increase the target voltage value by applying predetermined positive relationship data to the voltage difference between the first reference voltage value and the i-th node voltage value. When the target voltage value increases, $V_{node}[i]$ increases toward $V_{ref1}$ according to Equations 1-1 and 1-2, and the voltage difference between $V_{node}[i]$ and $V_{ref1}$ is reduced.

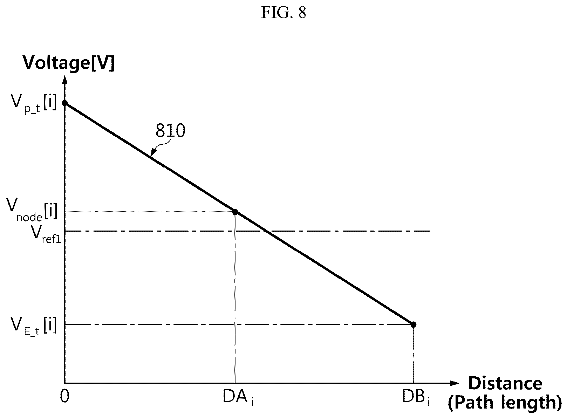

FIG. 8 is a diagram referenced in describing another example of voltage relationship of the converter, the node and the charging/discharging facility associated with the first control mode of the power facility set. To help understanding, the description will be made based on a situation where the converter $P_i$ set to the first control mode is in power supply operation.

Referring to FIG. 8, the slope of a voltage curve 810 passing through $V_{P\_t}[i]$, $V_{node}[i]$ and t[i] is a negative value. However, in contrast to FIG. 7, in FIG. 8, $V_{ref1} < V_{node}[i] < V_{E\_t}[i]$, and it is necessary to reduce $V_{node}[i]$. When $V_{node}[i]$ is not reduced, power may be dissipated through the adjacent nodes $N_{i-1}$, $N_{i+1}$.

To reduce $V_{node}[i]$, it is necessary to reduce $V_{P\_t}[i]$. Accordingly, the controller $CT_i$ may reduce the target voltage value by applying predetermined positive relationship data to the voltage difference between the first reference voltage value and the i-th node voltage value. When the target voltage value is reduced, $V_{node}[i]$ decreases toward $V_{ref1}$ according to Equations 1-1 and 1-2, and the voltage difference between $V_{node}[i]$ and $V_{ref1}$ is reduced.

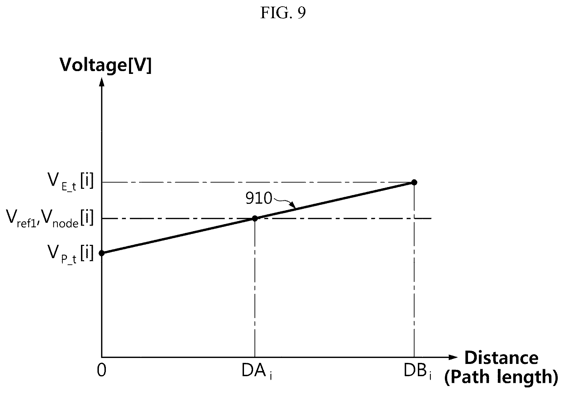

FIG. 9 is a diagram referenced in describing another example of voltage relationship of the converter, the node and the charging/discharging facility associated with the first control mode of the power facility set. To help understanding, the description will be made based on a situation where the converter $P_i$ set to the first control mode is in power regeneration operation.

Referring to FIG. 6 and FIG. 9 together, when the first control mode is set for the converter $P_i$ and the charging/discharging facility $C_i$ is in the discharge dominant state, the flow of current ($I_a$ in FIG. 6) from the node $N_i$ to the converter $P_i$ is generated. Accordingly, the slope of a voltage curve 910 passing through $V_{P\_t}[i]$, $V_{node}[i]$ and $V_{E\_t}[i]$ is a positive value.

$V_{node}[i]$ may be larger than $V_{P\_t}[i]$, and $V_{node}[i]$ may be nearly equal to $V_{ref1}$. When $V_{node}[i]$ is nearly equal to the voltages of the adjacent nodes $N_{i-1}$, $N_{i+1}$, most of power regenerated from the charging/discharging facility $C_i$ may be converted into AC power through the converter $P_i$ without being used by the other charging/discharging facility operating in the battery charge mode.

To prevent the above-described negative result, it is necessary to disable the first control mode set for the converter $P_i$ and set the second control mode while the charging/discharging facility $C_i$ is in the discharge dominant state.

When the flow of current from the i-th node $N_i$ to the converter $P_i$ (see the direction of $I_a$ in FIG. 6) lasts for a first reference time or longer, the controller $CT_i$ may set the second control mode for the converter $P_i$. For example, in response to the measured current value of the converter $P_i$ having the negative sign for the first reference time or longer, the controller $CT_i$ may disable the first control mode for the converter $P_i$ and enter the second control mode for the converter $P_i$.

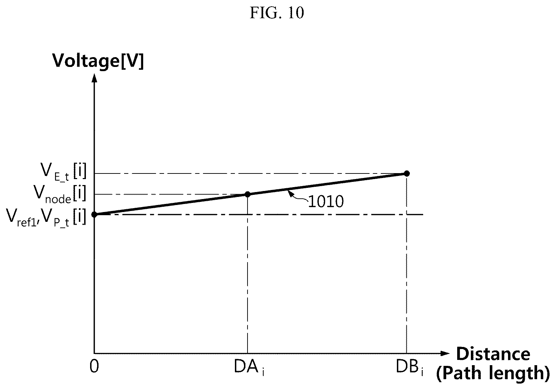

FIG. 10 is a diagram referenced in describing an example of voltage relationship of the converter, the node and the charging/discharging facility associated with the second control mode of the power facility set. To help understanding, assume that the control mode set for the converter $P_i$ is switched from the first control mode to the second control mode in the situation shown in FIG. 9.

When the second control mode is set for the converter $P_i$, the controller $CT_i$ determines the target voltage value of the converter $P_i$ to be equal to the second reference voltage value. As described above, the second reference voltage value is equal to or larger than the first reference voltage value, and $V_{ref1}$ in FIG. 10 indicates the second reference voltage value.

Referring to FIG. 6 and FIG. 10 together, because the converter $P_i$ is in power regeneration operation, the slope of a voltage curve 1010 passing through $V_{P\_t}[i]$, $V_{node}[i]$ and $V_{E\_t}[i]$ is a positive value.

When the voltage values of the adjacent nodes $N_{i-1}$, $N_{i+1}$ are almost equal to the first reference voltage value, power is transferred from the node $N_i$ of higher voltage to the adjacent nodes $N_{i-1}$, $N_{i+1}$ of lower voltage, and this represents that power regenerated from the charging/discharging facility $C_i$ may be supplied to the other charging/discharging facility operating in the battery charge mode.

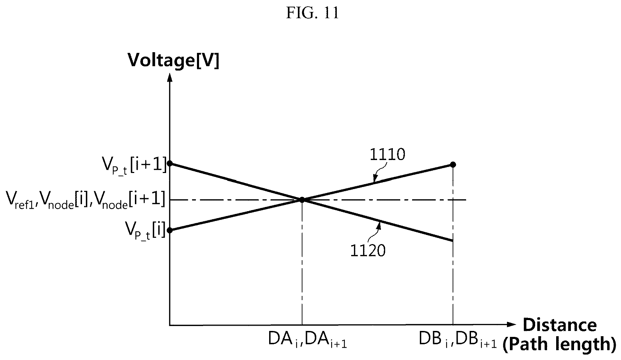

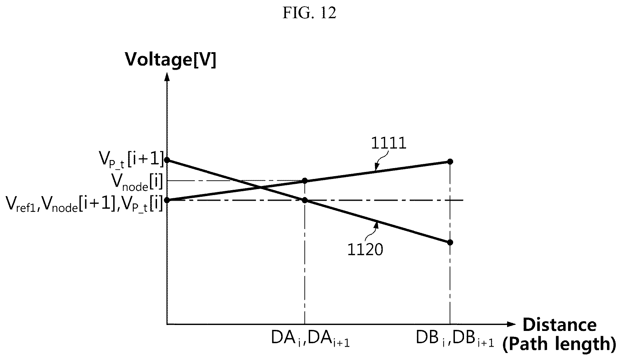

FIG. 11 is a diagram referenced in describing the disadvantage of maintaining the control mode for the converter in the power regeneration operation at the first control mode, and FIG. 12 is a diagram referenced in describing the advantage of switching the control mode for the converter in the power regeneration operation from the first control mode to the second control mode. For convenience of description, assume that the second reference voltage value is equal to the first reference voltage value, the converter $P_i$ is in the power regeneration operation, and the converter $P_{i+1}$ is in the power supply operation.

The graph shown in FIG. 11 corresponds to a situation where the first control mode is set for both the converter $P_i$ and the converter $P_{i+1}$.

Referring to FIG. 11, the slope of a voltage curve 1110 associated with the converter $P_i$ is a positive value, the slope of a voltage curve 1120 associated with the converter $P_{i+1}$ is a negative value, and the two node voltage values $V_{node}[i]$, $V_{node}[i+1]$ are approximately equal to the first reference voltage value $V_{ref1}$ as assumed above.

Because the two node voltage values $V_{node}[i]$, $V_{node}[i+1]$ are equal to each other or not so much different from each other, no current may flow in a portion of the shared power line ML connecting the two nodes $N_i$, $N_{i+1}$. Accordingly, most of power regenerated from the charging/discharging facility $C_i$ is not supplied to the charging/discharging facility $C_{i+1}$.

Subsequently, referring to FIG. 12, assume that the converter $P_{i+1}$ operates under the same conditions as FIG. 11, and accordingly, a voltage curve 1120 is the same as the voltage curve 1120 of FIG. 11. In contrast, the slope of a voltage curve 1111 associated with the converter $P_i$ is gentler than the voltage curve 1110, the measured voltage value $V_{P\_t}[i]$ is equal to the first reference voltage value, the node voltage value $V_{node}[i]$ is larger than the first reference voltage value, and this is the result of disabling the first control mode for the converter $P_i$ and setting the second control mode.

Accordingly, due to the voltage difference $V_{node}[i] - V_{node}[i+1]$ between the two adjacent nodes $N_i$, $N_{i+1}$, the flow of current (see $I_d$ in FIG. 6) from the node $N_i$ of higher voltage to the node $N_{i+1}$ of lower voltage is generated. Accordingly, in contrast to the situation shown in FIG. 11, some of power regenerated from the charging/discharging facility $C_i$ is supplied to the charging/discharging facility $C_{i+1}$.

The example of FIG. 12 shows a situation where the second reference voltage value is equal to the first reference voltage value, and when the second reference voltage value is larger than the first reference voltage value, the voltage difference $V_{node}[i] - V_{node}[i+1]$ is also larger than that of FIG. 12, thereby improving the power supply from the charging/discharging facility $C_i$ to the charging/discharging facility $C_{i+1}$.

When the flow of current from the converter $P_i$ to the i-th node $N_i$ (see the direction of $I_a$ in FIG. 5) lasts for a second reference time or longer in the second control mode set for the converter $P_i$, the controller $CT_i$ may set the first control mode for the converter $P_i$. For example, in response to the measured current value of the converter $P_i$ having the positive sign for the second reference time or longer, the controller $CT_i$ may disable the second control mode for the converter $P_i$ and enter the first control mode for the converter $P_i$.

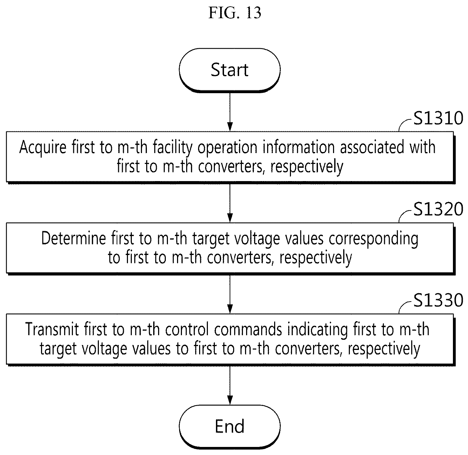

FIG. 13 is a flowchart schematically illustrating a system control method according to another embodiment of the present disclosure. The method according to FIG. 13 may be periodically or aperiodically performed by the system control apparatus 200 in a repeated manner while the charging/discharging process is performed by the battery charging/discharging system 10.

Referring to FIGS. 1 to 13, in step S1310, the first to m-th controllers $CT_1 \sim CT_m$ acquire the first to m-th facility operation information associated with the first to m-th converters $P_1 \sim P_m$, respectively. The i-th facility operation information includes the measured voltage value $V_{P\_t}[i]$ and the measured current value $I_{P\_t}[i]$ indicating the voltage and current of the DC power port $TP_i$ of the converter $P_i$, respectively.

In step S1320, the controller $CT_i$ determines the i-th target voltage value corresponding to the i-th converter $P_i$ of the first to m-th converters $P_1 \sim P_m$, based on the i-th facility operation information of the first to m-th facility operation information. When the first to m-th controllers $CT_1 \sim CT_m$ individually perform the step S1320, first to m-th target voltage values respectively corresponding to the first to m-th converters $P_1 \sim P_m$ may be determined.

In step S1330, the controller $CT_i$ individually transmits an i-th control command indicating the i-th target voltage value to the i-th converter $P_i$. Through the step S1330, first to m-th control commands may be transmitted to the first to m-th converters $P_1 \sim P_m$, respectively. The i-th converter $P_i$ may adjust the voltage of the DC power port $TP_i$ to match the i-th target voltage value in response to the i-th control command.

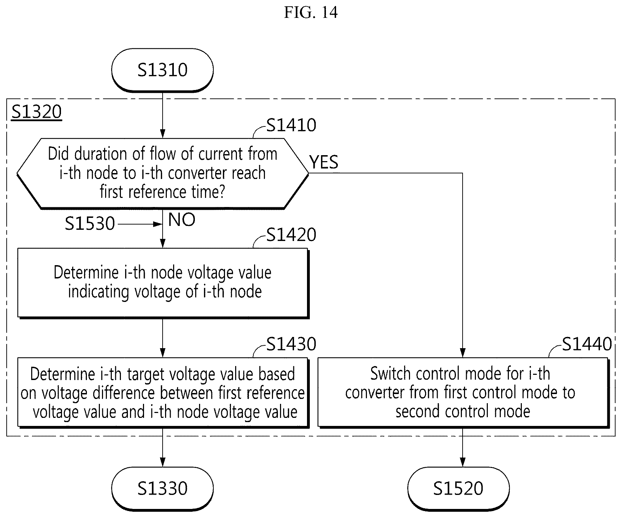

FIG. 14 is a flowchart schematically illustrating an example of subroutines that may be included in the step S1320 of FIG. 13. The method of FIG. 14 may be performed for each converter for which the first control mode is set among the first to m-th converters $P_1 \sim P_m$.

Referring to FIGS. 1 to 14, in step S1410, the controller $CT_i$ determines whether the duration of the flow of current from the i-th node $N_i$ to the i-th converter $P_i$ (see $I_a$ in FIG. 6) reaches the first reference time. When a value of the step S1410 is "NO", step S1420 may be performed. When the value of the step S1410 is "YES", step S1440 may be performed. For reference, the first reference time may be preset to prevent the step S1440 from being unintentionally performed (i.e., switching from the first control mode to the second control mode) when the flow of current from the i-th node $N_i$ to the i-th converter $P_i$ is temporarily generated due to the influence of the voltage and/or current of the adjacent nodes $N_{i-1}$, $N_{i+1}$.

In the step S1420, the controller $CT_i$ determines the i-th node voltage value $V_{node}[i]$ indicating the voltage of the i-th node $N_i$ based on the i-th facility operation information.

In step S1430, the controller $CT_i$ determines the i-th target voltage value based on the voltage difference between the first reference voltage value $V_{ref1}$ and the i-th node voltage value $V_{node}[i]$.

Where $V_{ref1} > V_{node}[i]$, as $V_{ref1} - V_{node}[i]$ is larger, the larger i-th target voltage value may be determined. Where $V_{ref1} < V_{node}[i]$, as $V_{node}[i] - V_{ref1}$ is larger, the smaller i-th target voltage value may be determined.

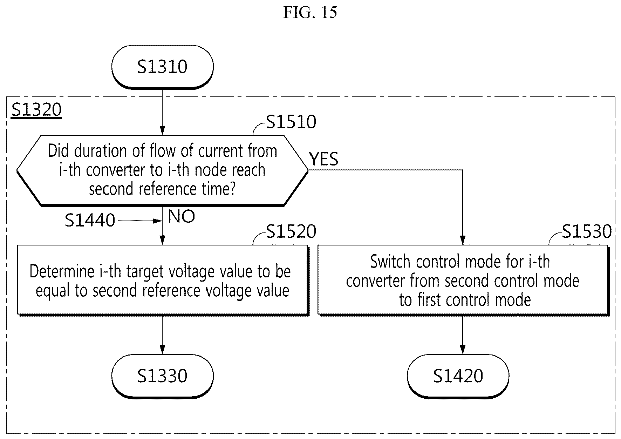

In the step S1440, the controller $CT_i$ switches the control mode for the i-th converter $P_i$ from the first control mode to the second control mode. Setting the second control mode for the i-th converter $P_i$ is done to reduce the connection strength between the i-th charging/discharging facility $C_i$ and the i-th converter $P_i$. When the step S1440 is completed, the method may move to step S1520 as described with reference to FIG. 15 below.

FIG. 15 is a flowchart schematically illustrating another example of subroutines that may be included in the step S1320 of FIG. 13. The method of FIG. 15 may be performed for each converter for which the second control mode is set among the first to m-th converters $P_1 \sim P_m$.

Referring to FIGS. 1 to 15, in step S1510, the controller $CT_i$ determines whether the duration of the flow of current from the i-th converter $P_i$ to the i-th node $N_i$ (see $I_a$ in FIG. 5) reaches the second reference time. When a value of the step S1510 is "NO", step S1520 may be performed. When the value of the step S1510 is "YES", step S1530 may be performed. For reference, the second reference time may be preset to prevent the step S1530 from being unintentionally performed (i.e., switching from the second control mode to the first control mode) when the flow of current from the i-th converter $P_i$ to the i-th node $N_i$ is temporarily generated due to the influence of the voltage and/or current of the adjacent nodes $N_{i-1}$, $N_{i+1}$.

In the step S1520, the controller $CT_i$ determines the i-th target voltage value to be equal to the second reference voltage value.

In the step S1530, the controller $CT_i$ switches the control mode for the i-th converter $P_i$ from the second control mode to the first control mode. When the step S1530 is completed, the method may move to the step S1420 of FIG. 14.

The embodiments of the present disclosure as described above are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the scope of the technical aspects of the present disclosure and the appended claims and their equivalents.

Additionally, as many substitutions, modifications and changes may be made to the present disclosure as described above by those skilled in the art without departing from the technical aspects of the present disclosure, the present disclosure is not limited by the disclosed embodiments and the accompanying drawings, and some or all of the embodiments may be selectively combined to allow various modifications.

**Claims**

1. A system control apparatus for a battery charging/discharging system including first to m-th converters and first to m-th charging/discharging facilities respectively connected through first to m-th nodes on a shared power line, the system control apparatus comprising:

    first to m-th controllers to acquire first to m-th facility operation information including a measured voltage value and a measured current value respectively indicating a voltage and a current of a direct current (DC) power port of each of the first to m-th converters, wherein an i-th controller of the first to m-th controllers is configured to:

        determine an i-th target voltage value corresponding to an i-th converter of the first to m-th converters based on i-th facility operation information of the first to m-th facility operation information, and transmit an i-th control command indicating the i-th target voltage value to the i-th converter, wherein m is a natural number of 2 or greater and i is a natural number equal to or smaller than m.

2. The system control apparatus according to claim 1, wherein the i-th controller is configured to:
    perform the following operations for increasing a connection strength between an i-th charging/discharging facility of the first to m-th charging/discharging facilities and the i-th converter when a first control mode is set for the i-th converter, the operations including:

        an operation of determining an i-th node voltage value indicating a voltage of an i-th node of the first to m-th nodes based on the i-th facility operation information; and
        an operation of determining the i-th target voltage value based on a voltage difference between a predetermined first reference voltage value and the i-th node voltage value.

3. The system control apparatus according to claim 2, wherein the i-th controller is configured to:
    determine the i-th node voltage value by subtracting an i-th voltage drop value corresponding to the i-th measured current value from the i-th measured voltage value.

4. The system control apparatus according to claim 2, wherein the i-th controller is configured to:
    determine the i-th target voltage value by applying a predetermined positive correspondence relationship to the voltage difference to reduce the voltage difference.

5. The system control apparatus according to claim 2, wherein the i-th controller is configured to:
    switch a control mode for the i-th converter from the first control mode to a second control mode for reducing the connection strength between the i-th charging/discharging facility and the i-th converter when a duration of a flow of current from the i-th node to the i-th converter reaches a first reference time while the first control mode is set for the i-th converter.

6. The system control apparatus according to claim 5, wherein the i-th controller is configured to:
    determine the i-th target voltage value to be equal to a second reference voltage value when the second control mode is set for the i-th converter.

7. The system control apparatus according to claim 6, wherein the second reference voltage value is equal to or larger than the first reference voltage value.

8. The system control apparatus according to claim 5, wherein the i-th controller is configured to:
disable the second control mode and enter the first control mode when the flow of current from the i-th converter to the i-th node lasts for a second reference time or longer while the second control mode is set for the i-th converter.

9. The system control apparatus according to claim 1,

wherein an i-th shortest path resistance value is smallest among first to m-th shortest path resistance values of the i-th converter, and
wherein the first to m-th shortest path resistance values of the i-th converter correspond to shortest paths from the DC power port of the i-th converter to the DC power ports of the first to m-th charging/discharging facilities, respectively.

10. A battery charging/discharging system comprising the system control apparatus according to any one of claims 1 to 9.

11. A system control method performed by a system control apparatus for a battery charging/discharging system including first to m-th converters respectively connected to first to m-th nodes on a shared power line, and first to m-th charging/discharging facilities respectively connected to the first to m-th nodes, through first to m-th main lines, the system control method comprising:

acquiring, by first to m-th controllers included in the system control apparatus, first to m-th facility operation information including a measured voltage value and a measured current value respectively indicating a voltage and a current of a direct current (DC) power port of each of the first to m-th converters;
determining, by an i-th controller of the first to m-th controllers, an i-th target voltage value corresponding to an i-th converter of the first to m-th converters based on i-th facility operation information of the first to m-th facility operation information; and
transmitting, by the i-th controller, an i-th control command indicating the i-th target voltage value to the i-th converter,
wherein m is a natural number of 2 or greater, and i is a natural number equal to or smaller than m.

12. The system control method according to claim 11,

wherein the determining of the i-th target voltage value comprises:
performing the following steps for increasing a connection strength between an i-th charging/discharging facility of the first to m-th charging/discharging facilities and the i-th converter when a first control mode is set for the i-th converter, the steps comprising:

determining an i-th node voltage value indicating a voltage of an i-th node of the first to m-th nodes based on the i-th facility operation information; and
determining the i-th target voltage value based on a voltage difference between a predetermined first reference voltage value and the i-th node voltage value.

13. The system control method according to claim 12, wherein the determining of the i-th target voltage value comprises:
determining the i-th target voltage value by applying a predetermined positive correspondence relationship to the voltage difference to reduce the voltage difference.

14. The system control method according to claim 12, wherein the determining of the i-th target voltage value further comprises:
switching a control mode for the i-th converter from the first control mode to a second control mode for reducing the connection strength between the i-th charging/discharging facility and the i-th converter when a duration of a flow of current from the i-th node to the i-th converter reaches a first reference time.

15. The system control method according to claim 14, wherein the determining of the i-th target voltage value further comprises:
determining the i-th target voltage value to be equal to a second reference voltage value when the second control mode is set for the i-th converter.

FIG. 1

┌─────────────────────────────────────────┐ ⌐10
│ Battery charging/discharging system      │
│                                    ⌐100  │
│   ┌────────────────────────┐             │
│   │ Power conversion system│             │
│   └────────────────────────┘             │
│                                    ⌐200  │
│   ┌────────────────────────┐             │
│   │ System control apparatus│            │
│   └────────────────────────┘             │
└─────────────────────────────────────────┘

FIG. 2

FIG. 3

FIG. 4

FIG. 5

<During power supply>

FIG. 6

\<During power regeneration\>

FIG. 7

FIG. 8

FIG. 9

FIG. 10

FIG. 11

FIG. 12

FIG. 13

```
            ╭─────────╮
            │  Start  │
            ╰────┬────╯
                 │                                    ⌐S1310
    ┌────────────▼──────────────────────────────────────┐
    │ Acquire first to m-th facility operation information associated with │
    │            first to m-th converters, respectively │
    └────────────┬──────────────────────────────────────┘
                 │                                    ⌐S1320
    ┌────────────▼──────────────────────────────────────┐
    │    Determine first to m-th target voltage values corresponding │
    │           to first to m-th converters, respectively │
    └────────────┬──────────────────────────────────────┘
                 │                                    ⌐S1330
    ┌────────────▼──────────────────────────────────────┐
    │ Transmit first to m-th control commands indicating first to m-th │
    │   target voltage values to first to m-th converters, respectively │
    └────────────┬──────────────────────────────────────┘
                 │
            ╭────▼────╮
            │   End   │
            ╰─────────╯
```

FIG. 14

```
                    ┌──────────────┐
                    │    S1310     │
                    └──────┬───────┘
┌─────────────────────────┼──────────────────────────────────────────────┐
│ S1320                    │                                              │
│                          ▼          ╱S1410                              │
│            ╱───────────────────────────╲                               │
│           ╱  Did duration of flow of     ╲  YES                        │
│          ⟨   current from i-th node to     ⟩─────────────┐             │
│           ╲  i-th converter reach         ╱              │             │
│            ╲  first reference time?     ╱                │             │
│              ╲────────────────────────╱                  │             │
│         S1530 ──────▶│ NO                                 │             │
│                      ▼          ╱S1420                    │             │
│          ┌─────────────────────────────┐                 │             │
│          │ Determine i-th node voltage  │                │             │
│          │ value indicating voltage of  │                │             │
│          │ i-th node                    │                │             │
│          └──────────────┬───────────────┘                │             │
│                         ▼       ╱S1430           ╱S1440   ▼             │
│   ┌──────────────────────────────┐   ┌──────────────────────────────┐  │
│   │ Determine i-th target voltage │   │ Switch control mode for i-th  │  │
│   │ value based on voltage        │   │ converter from first control  │  │
│   │ difference between first      │   │ mode to second control mode   │  │
│   │ reference voltage value and   │   │                              │  │
│   │ i-th node voltage value       │   │                              │  │
│   └──────────────┬───────────────┘   └──────────────┬───────────────┘  │
└──────────────────┼──────────────────────────────────┼──────────────────┘
                   ▼                                   ▼
            ┌──────────────┐                    ┌──────────────┐
            │    S1330     │                    │    S1520     │
            └──────────────┘                    └──────────────┘
```

FIG. 15

```
                        ┌─────────────┐
                        │    S1310    │
                        └──────┬──────┘
  ┌─ S1320 ─────────────────── │ ────────────────────────────────────┐
  │                            │                S1510                 │
  │              ╱─────────────▼──────────────╲                       │
  │            ╱  Did duration of flow of current from ╲  YES         │
  │           ⟨   i-th converter to i-th node reach      ⟩────────┐    │
  │            ╲      second reference time?           ╱          │    │
  │              ╲──────────────┬──────────────╱                  │    │
  │          S1440 ─────► NO    │                                 │    │
  │                       S1520 │                         S1530   │    │
  │        ┌───────────────────▼──────────┐   ┌──────────────────▼──┐ │
  │        │ Determine i-th target voltage │   │ Switch control mode for i-th │
  │        │ value to be equal to second   │   │ converter from second control │
  │        │ reference voltage value       │   │ mode to first control mode    │
  │        └───────────────┬───────────────┘   └──────────────┬──────┘ │
  │                        │                                   │        │
  │                 ┌──────▼──────┐                    ┌───────▼──────┐ │
  │                 │    S1330    │                    │    S1420     │ │
  │                 └─────────────┘                    └──────────────┘ │
  └────────────────────────────────────────────────────────────────────┘
```

## INTERNATIONAL SEARCH REPORT

| | International application No. |
|---|---|
| | **PCT/KR2025/099630** |

**A. CLASSIFICATION OF SUBJECT MATTER**

**H02J 7/00**(2006.01)i; **G01R 31/3842**(2019.01)i

According to International Patent Classification (IPC) or to both national classification and IPC

**B. FIELDS SEARCHED**

Minimum documentation searched (classification system followed by classification symbols)

H02J 7/00(2006.01); B60L 11/18(2006.01); G01R 31/382(2019.01); H02J 3/38(2006.01); H02J 7/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 충방전(charge and discharge), 변환기(converter), 목표전압(target voltage)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2012-0103337 A (SAMSUNG SDI CO., LTD.) 19 September 2012 (2012-09-19) See paragraphs [0033]-[0044] and figures 1-2. | 1,9-11 |
| A | | 2-8,12-15 |
| Y | KR 10-0944528 B1 (IN-TECH FACTORY AUTOMATION CO., LTD.) 05 March 2010 (2010-03-05) See paragraphs [0032]-[0034] and figures 3-4. | 1,9-11 |
| A | KR 10-2023-0153001 A (KOREA INSTITUTE OF INDUSTRIAL TECHNOLOGY) 06 November 2023 (2023-11-06) See paragraphs [0035]-[0085] and figures 1-5. | 1-15 |
| A | US 2010-0213897 A1 (TSE, Lawrence Tze-Leung) 26 August 2010 (2010-08-26) See paragraphs [0034]-[0053] and figures 5a-13. | 1-15 |
| A | JP 2015-186291 A (UNIV. OF TOKYO) 22 October 2015 (2015-10-22) See paragraphs [0020]-[0069] and figures 2-4. | 1-15 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **09 June 2025** | **09 June 2025** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 726 958 A1**

## INTERNATIONAL SEARCH REPORT
### Information on patent family members

International application No.

**PCT/KR2025/099630**

| Patent document cited in search report | | | Publication date (day/month/year) | Patent family member(s) | | | Publication date (day/month/year) |
|---|---|---|---|---|---|---|---|
| KR | 10-2012-0103337 | A | 19 September 2012 | CN | 102684273 | A | 19 September 2012 |
| | | | | CN | 102684273 | B | 25 November 2015 |
| | | | | KR | 10-1733742 | B1 | 25 May 2017 |
| KR | 10-0944528 | B1 | 05 March 2010 | None | | | |
| KR | 10-2023-0153001 | A | 06 November 2023 | KR | 10-2672050 | B1 | 04 June 2024 |
| US | 2010-0213897 | A1 | 26 August 2010 | CN | 102948033 | A | 27 February 2013 |
| | | | | CN | 102948033 | B | 12 August 2015 |
| | | | | EP | 2548283 | A2 | 23 January 2013 |
| | | | | JP | 2013-520947 | A | 06 June 2013 |
| | | | | US | 2013-0038289 | A1 | 14 February 2013 |
| | | | | WO | 2011-103469 | A2 | 25 August 2011 |
| | | | | WO | 2011-103469 | A3 | 15 December 2011 |
| JP | 2015-186291 | A | 22 October 2015 | None | | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240045427